# EUROPEAN PATENT APPLICATION

(11) **EP 4 766 066 A1**
(43) Date of publication of application: **24.06.2026**
(21) Application number: 23949052.7
(22) Date of filing: 21.11.2023
(51) Int. Cl.: H10B 41/30, H10B 41/42, H10D 30/01

(54) **MANUFACTURING METHOD FOR STORAGE DEVICE, AND STORAGE DEVICE**

(30) Priority: 16.08.2023 CN 202311044576
(71) Applicant: Wuhan Xinxin Semiconductor Manufacturing Co., Ltd., Wuhan, Hubei 430205 (CN)
(72) Inventor: GONG, Fengcong, Wuhan, Hubei 430205 (CN); CAO, Kaiwei, Wuhan, Hubei 430205 (CN)
(74) Representative: De Arpe Tejero, Manuel
(86) International application number: PCT/CN2023/133013
(87) International publication number: WO 2025/035635

(57) **Abstract**

Disclosed are a manufacturing method for a storage device, and a storage device. The manufacturing method comprises: providing a semiconductor substrate, which comprises a base and a hard mask layer on the base; forming a plurality of first recesses in an active region of the base from the hard mask layer, some of the first recesses being located in a storage region and the rest being located in a lead-out region, and the portion of each first recess in the base being defined as a substrate recess; forming gate insulating layers and semi-floating gates at the bottoms of the substrate recesses, one portion of each semi-floating gate being in contact with the base, and the other portion thereof being isolated from the base by means of the corresponding gate insulating layer; and respectively forming inter-gate dielectric layers and first gate layers in the first recesses, forming control gates of storage units in the first recesses in the storage region, and forming lead-out wires of the storage units in the first recesses of in the lead-out region. That is, according to the present application, the lead-out region can be in contact with the outside, solving the problem of voltage drop caused by large buried gate resistance.

## Description

### TECHNICAL FIELD

The present disclosure relates to the field of semiconductor technology, and in particular to a manufacturing method for a memory device and a memory device.

### BACKGROUND

During the application of integrated circuits, the performance of various devices is influenced by the interfacial contact area between different material layers. This effect is particularly pronounced in memory devices, where the contact area directly impacts power dissipation.

In practical operations, the R&D personnel involved in the present disclosure have identified that current semiconductor manufacturing solutions-especially for memory devices-result in buried-gate structures that exhibit insufficient coupling between the control gate and the semi-floating gate. This deficiency leads to elevated operating voltage requirements and substantial power consumption, ultimately compromising the performance efficacy of the memory devices.

### SUMMARY OF THE DISCLOSURE

The embodiments of the present disclosure provide a manufacturing method for a memory device and a memory device.

A manufacturing method for a memory device, including:
providing a semiconductor substrate, wherein the semiconductor substrate includes a substrate and a hard mask layer on the substrate;
defining a plurality of first trenches in active areas of the substrate from the hard mask layer; wherein some of the plurality of first trenches are located in a memory region, and others of the plurality of first trenches are located in a lead-out region; a portion of each first trench in the substrate is defined as a base trench;
forming a gate insulating layer and a semi-floating gate on a bottom of each base trench; wherein a portion of the semi-floating gate is in contact with the substrate, and another portion of the semi-floating gate is isolated from the substrate by the gate insulating layer; and
forming an inter-gate dielectric layer and a first gate layer in each first trench, removing a portion of the first gate layer in each first trench in the memory region to form a control gate of a corresponding memory cell, and retaining the first gate layer in each first trenches in the lead-out region as a lead-out line of a corresponding memory cell; wherein the lead-out line is connected to the control gates of memory cells in a same row as the lead-out line.

A memory device, including:
a substrate;
a plurality of base trenches; wherein each base trench extends from a side surface of the substrate toward the substrate; some of the plurality of base trenches are located in a memory region, and others of the plurality of base trenches are located in a lead-out region; an inner wall on a bottom of each base trench is arranged with a gate insulating layer;
a semi-floating gate; wherein the semi-floating gate fills the bottom of the base trench; a portion of the semi-floating gate is isolated from the substrate by the gate insulating layer, and another portion of the semi-floating gate is in contact with the substrate;
an inter-gate dielectric layer, covering the semi-floating gate; and
a first gate layer, formed on the inter-gate dielectric layer; wherein the first gate layer in the memory region constitutes a control gate of a corresponding memory cell in the memory device, and the first gate layer in the lead-out region serves as a lead-out line, which connects the control gates of memory cells in a same row.

The details of one or more embodiments of the present disclosure are presented in the accompanying drawings and descriptions below. Other features, objectives, and advantages of the present disclosure will become apparent from the description, drawings, and claims.

### BRIEF DESCRIPTION OF THE DRAWINGS

To more clearly illustrate the technical solutions of the embodiments of the present disclosure, the following is a brief introduction to the drawings used in the description of the embodiments. It is obvious that the drawings described below are only some embodiments of the present disclosure. For those skilled in the art, other drawings may be obtained based on these drawings without creative labor.

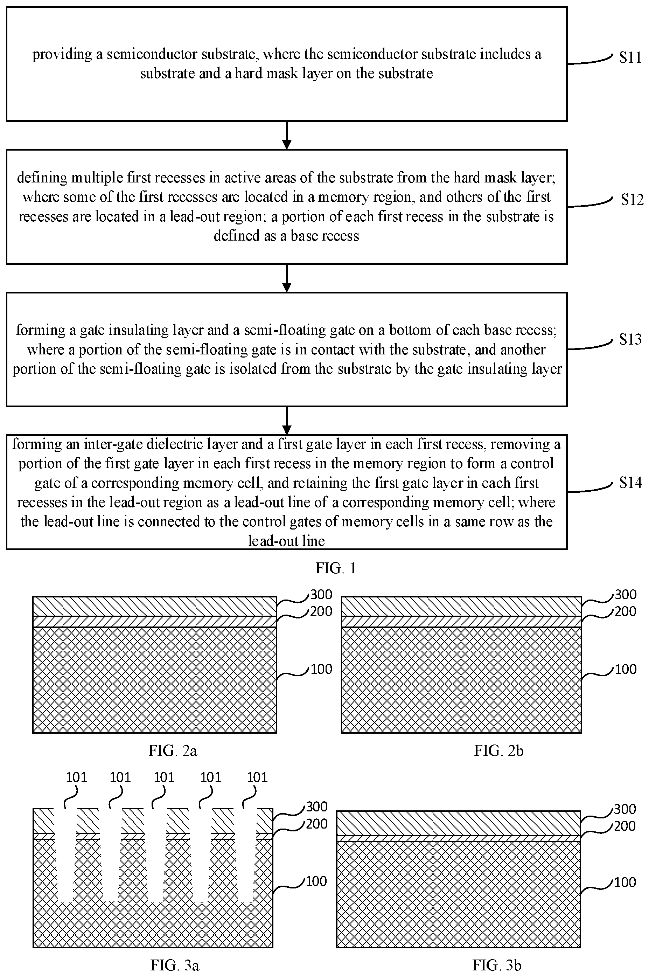

FIG. 1 is a flowchart of a manufacturing method for a memory device according to some embodiments of the present disclosure.
FIG. 2a is a schematic structural view of a semiconductor substrate viewed in a first direction according to some embodiments of the present disclosure; FIG. 2b is a schematic structural view of the semiconductor substrate viewed in a second direction according to some embodiments of the present disclosure.
FIG. 3a is a schematic structural view of defining multiple second trenches in a substrate viewed in the first direction according to some embodiments of the present disclosure; FIG. 3b is a schematic structural view of defining the second trenches in the substrate viewed in the second direction according to some embodiments of the present disclosure.

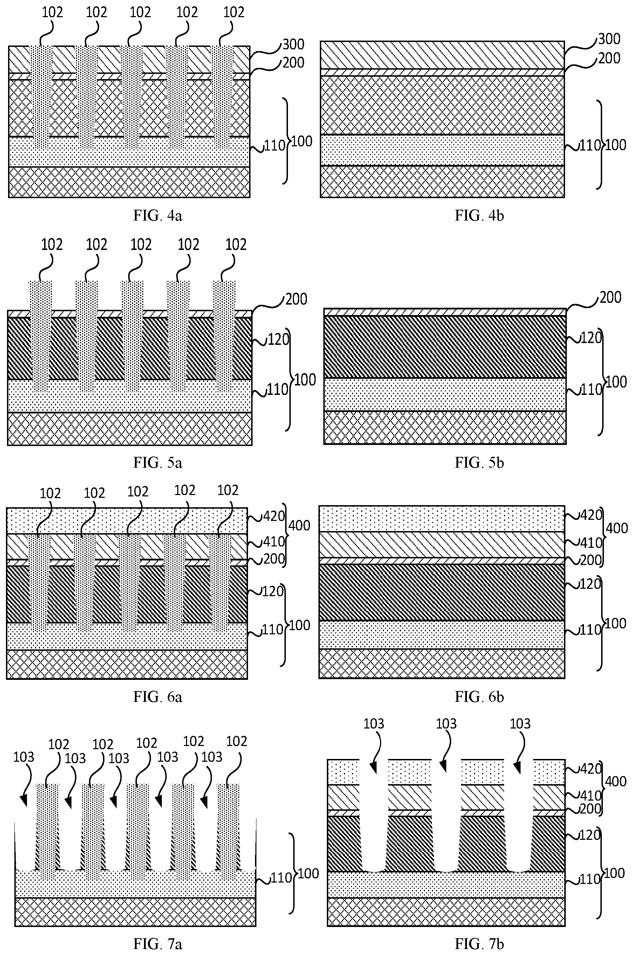

FIG. 4a is a schematic structural view of forming shallow trench isolation (STI) structures viewed in the first direction according to some embodiments of the present disclosure; FIG. 4b is a schematic structural view of forming the STI structure viewed in the second direction according to some embodiments of the present disclosure.
FIG. 5a is a schematic structural view of forming a second well region viewed in the first direction according to some embodiments of the present disclosure; FIG. 5b is a schematic structural view of forming the second well region viewed in the second direction according to some embodiments of the present disclosure.
FIG. 6a is a schematic structural view of forming a filling cover layer viewed in the first direction according to some embodiments of the present disclosure; FIG. 6b is a schematic structural view of forming the filling cover layer viewed in the second direction according to some embodiments of the present disclosure.
FIG. 7a is a schematic structural view of defining multiple first trenches viewed in the first direction according to some embodiments of the present disclosure; FIG. 7b is a schematic structural view of defining the first trenches viewed in the second direction according to some embodiments of the present disclosure.

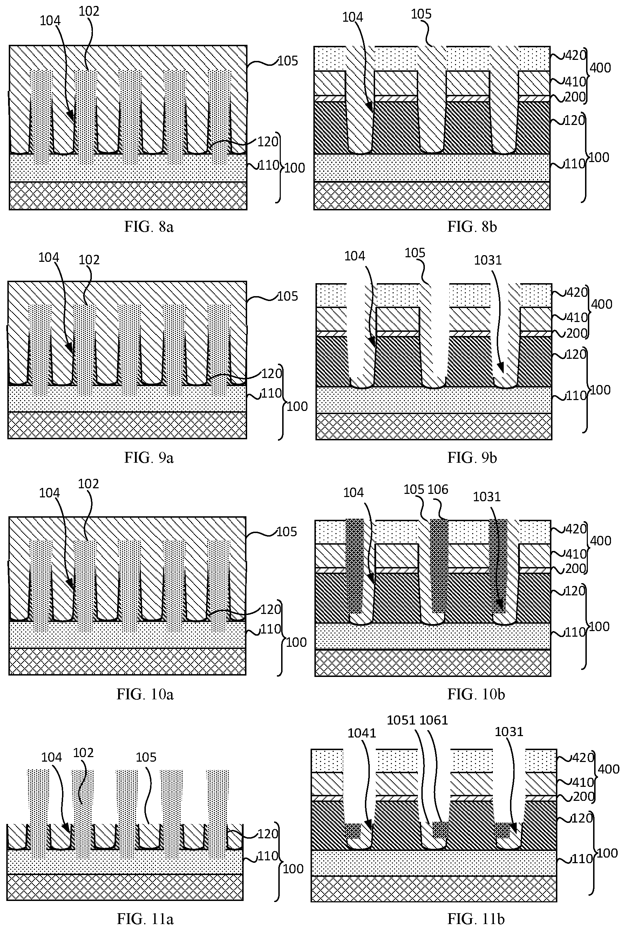

FIG. 8a is a schematic structural view of filling a second gate material viewed in the first direction according to some embodiments of the present disclosure; FIG. 8b is a schematic structural view of filling the second gate material viewed in the second direction according to some embodiments of the present disclosure.
FIG. 9a is a schematic structural view of forming a contact window viewed in the first direction according to some embodiments of the present disclosure; FIG. 9b is a schematic structural view of forming the contact window viewed in the second direction according to some embodiments of the present disclosure.
FIG. 10a is a schematic structural view of filling a third gate material viewed in the first direction according to some embodiments of the present disclosure; FIG. 10b is a schematic structural view of filling the third gate material viewed in the second direction according to some embodiments of the present disclosure.
FIG. 11a is a schematic structural view of removing portions of the second gate material, the third gate material, and a first insulating layer in the first trench viewed in the first direction according to some embodiments of the present disclosure; FIG. 11b is a schematic structural view of removing portions of the second gate material, the third gate material, and the first insulating layer in the first trench viewed in the second direction according to some embodiments of the present disclosure.

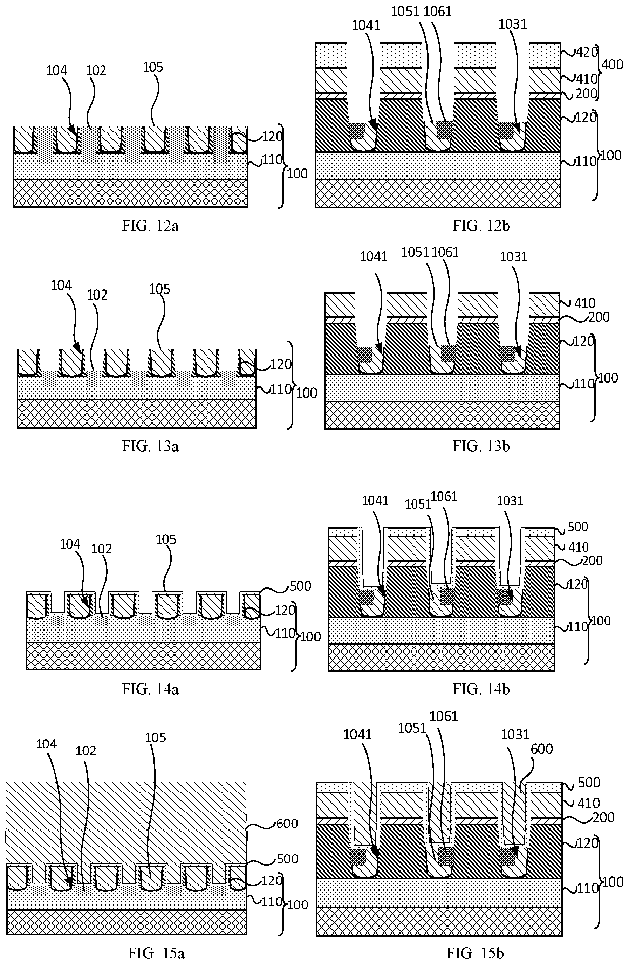

FIG. 12a is a schematic structural view of forming a first isolation portion viewed in the first direction according to some embodiments of the present disclosure; FIG. 12b is a schematic structural view of forming the first isolation portion viewed in the second direction according to some embodiments of the present disclosure.
FIG. 13a is a schematic structural view of further lowering the STI structure to form another first isolation portion viewed in the first direction according to some embodiments of the present disclosure; FIG. 13b is a schematic structural of further lowering the STI structure to form another first isolation portion view viewed in the second direction according to some embodiments of the present disclosure.
FIG. 14a is a schematic structural view of forming an inter-gate dielectric layer viewed in the first direction according to some embodiments of the present disclosure; FIG. 14b is a schematic structural view of forming the inter-gate dielectric layer viewed in the second direction according to some embodiments of the present disclosure.
FIG. 15a is a schematic structural view of covering a first gate material viewed in the first direction according to some embodiments of the present disclosure; FIG. 15b is a schematic structural view of covering the first gate material viewed in the second direction according to some embodiments of the present disclosure.

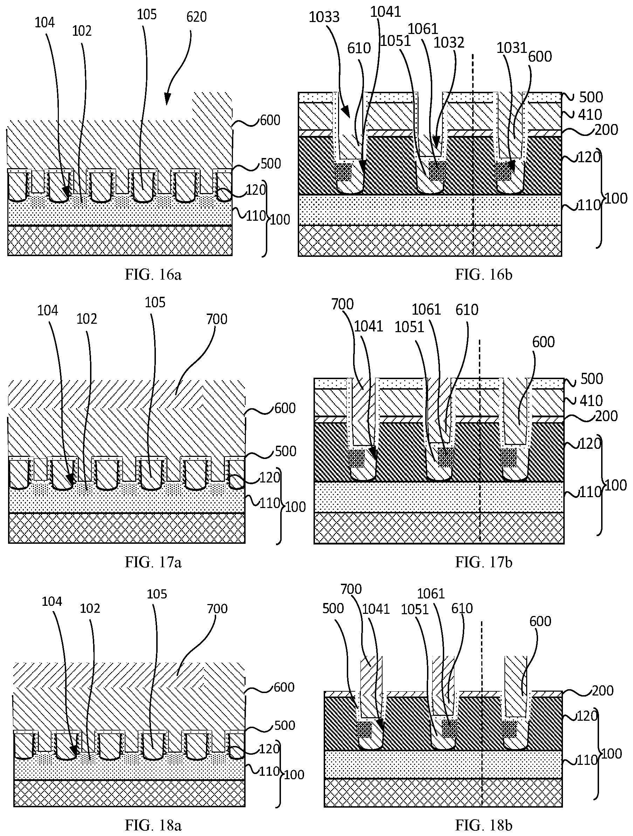

FIG. 16a is a schematic structural view of removing portions of the first gate material viewed in the first direction according to some embodiments of the present disclosure; FIG. 16b is a schematic structural view of removing portions of the first gate material viewed in the second direction according to some embodiments of the present disclosure.
FIG. 17a is a schematic structural view of forming a second insulating layer viewed in the first direction according to some embodiments of the present disclosure; FIG. 17b is a schematic structural view of forming a first trench in the second insulating layer viewed in the second direction according to some embodiments of the present disclosure.
FIG. 18a is a schematic structural view of removing portions of the first insulating layer and the filling cover layer viewed in the first direction according to some embodiments of the present disclosure; FIG. 18b is a schematic structural view of removing portions of the first insulating layer and the filling cover layer viewed in the second direction according to some embodiments of the present disclosure.

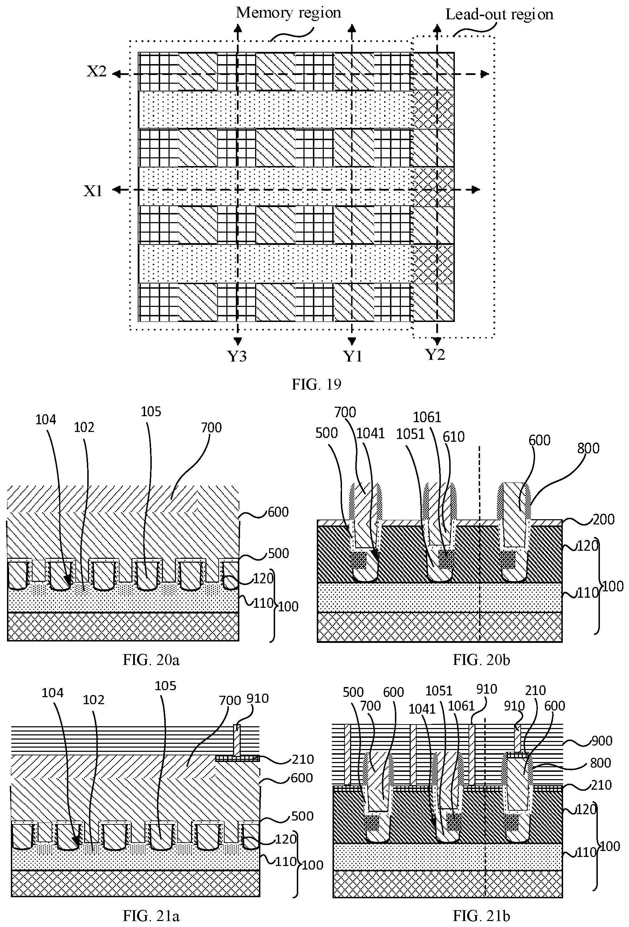

FIG. 19 is a top view of a memory device according to some embodiments of the present disclosure.
FIG. 20a is a schematic structural view of forming an isolation barrier wall viewed in the first direction according to some embodiments of the present disclosure; FIG. 20b is a schematic structural view of forming the isolation barrier wall viewed in the second direction according to some embodiments of the present disclosure.
FIG. 21a is a schematic structural view of forming a contact plug in an interlayer dielectric (ILD) layer viewed in the first direction according to some embodiments of the present disclosure; FIG. 21b is a schematic structural view of forming the contact plug in the ILD layer viewed in the second direction according to some embodiments of the present disclosure.

Reference Numerals: Substrate 100; Second trench 101; Shallow trench isolation (STI) structure 102; First trench 103; First slot segment 1031; Second slot segment 1032; Spare region 1033; First insulating layer 104; Gate insulating layer 1041; Second gate material 105; Second gate 1051; Third gate material 106; Third gate 1061; First dielectric layer 200; Metal silicide layer 210; Second dielectric layer 300; Filling cover layer 400; Filling layer 410; First protective layer 420; Inter-gate dielectric layer 500; First gate material 600; First gate layer 610; Unoccupied region 620; Second insulating layer 700; Isolation barrier wall 800; Interlayer dielectric (ILD) layer 900; Contact plug 910.

### DETAILED DESCRIPTION

The following description will refer to the accompanying drawings of the embodiments of the present disclosure to provide a clear and complete description of the technical solutions of the embodiments of the present disclosure. It should be noted that the embodiments described herein are merely some examples of the embodiments of the present disclosure and not all of them. All other embodiments obtained by those skilled in the art based on the embodiments of the present disclosure without involving creative labor are within the scope of the present disclosure.

In the current manufacturing process of memory devices, especially in the manufacturing of memory devices, when forming a buried gate structure using a semi-floating gate, the high resistance of the buried gate causes voltage drop issues and often results in insufficient coupling between the control gate and the semi-floating gate. This leads to elevated operating voltage and substantial power consumption, ultimately compromising the performance efficacy of the memory devices.

Therefore, a manufacturing method for a memory device is hereby provided, enabling the lead-out lines in the lead-out region to contact with the external environment, thereby resolving the voltage drop issues caused by the high resistance of the buried control gate, while reducing the operating voltage of the memory device to lower power consumption.

Referring to FIG. 1, FIG. 1 is a flowchart of a manufacturing method for a memory device according to some embodiments of the present disclosure.

The manufacturing method according to the present disclosure includes the following operations at blocks illustrated in FIG. 1.

At block S11: providing a semiconductor substrate, where the semiconductor substrate includes a substrate and a hard mask layer on the substrate.

The semiconductor substrate in S11 is shown in FIGS. 6a and 6b. In some embodiments, the operation S11 includes:
providing a substrate, and sequentially forming a first dielectric layer and a second dielectric layer on the substrate.

The substrate may be any suitable substrate known in the art, such as at least one of the following materials: silicon (Si), germanium (Ge),silicon germanium (SiGe), silicon carbide (SiC), silicon germanium carbide (SiGeC), indium arsenide (InAs), gallium arsenide (GaAs), indium phosphide (InP), and other III/V compound semiconductors, as well as multi-layer structures composed of these semiconductors, or silicon on insulator (SOI), silicon stacked on insulator (SSOI), silicon stacked on germanium oxide (S-SiGeOI), germanium oxide on silicon (SiGeOI), and germanium oxide on germanium (GeOI).

Referring to FIGS. 2a and 2b, FIG. 2a is a schematic structural view of a semiconductor substrate viewed in the first direction according to some embodiments of the present disclosure; FIG. 2b is a schematic structural view of the semiconductor substrate viewed in the second direction according to some embodiments of the present disclosure.

Specifically, a substrate 100 is provided, and a first dielectric layer 200 and a second dielectric layer 300 are sequentially formed on the substrate 100.

In some embodiments, the first dielectric layer 200 may be an oxide layer, such as a silicon oxide layer, and the second dielectric layer 300 may be a nitride layer, such as a silicon nitride layer.
defining second trenches from the second dielectric layer toward the substrate; where the second trenches are spaced apart along a first direction and extend along a second direction.

The first direction is the wordline (WL) extension direction, and the first direction is also the X direction. The second direction is the bitline (BL) extension direction, and the second direction is also the Y direction. That is, the first direction and the second direction are perpendicular to each other in the same horizontal plane.

Referring to FIGS. 3a and 3b, FIG. 3a is a schematic structural view of defining multiple second trenches in a substrate viewed in the first direction according to some embodiments of the present disclosure; FIG. 3b is a schematic structural view of defining the second trenches in the substrate viewed in the second direction according to some embodiments of the present disclosure.

As shown in FIG. 3a, in the first direction, the second trenches 101 are defined in the substrate 100 from the second dielectric layer 300. In the second direction, the first dielectric layer 200 and the second dielectric layer 300 are sequentially formed on the substrate 100.

In some embodiments, multiple second trenches 101 are sequentially spaced apart along the first direction (X direction), and a bottom of each second trench 101 is higher than a bottom of the substrate 100, i.e., the second trench 101 extends into a portion of the substrate 100.
filling each second trench with an insulating material to form a shallow trench isolation (STI) structure; and performing ion implantation to form a first well region in the substrate.

Referring to FIGS. 4a and 4b, FIG. 4a is a schematic structural view of forming shallow trench isolation (STI) structures viewed in the first direction according to some embodiments of the present disclosure; FIG. 4b is a schematic structural view of forming the STI structure viewed in the second direction according to some embodiments of the present disclosure.

As shown in FIG. 4a, in the first direction, the second trench 101 is filled with an insulating material to form the STI structure 102, and then the substrate 100 is subjected to ion implantation to form the first well region 110 in the substrate 100; where the STI structure 102 extends within the first well region 110, i.e., a bottom of the STI structure 102 is higher than a bottom of the first well region 110 and lower than a top of the first well region 110. As shown in FIG. 4b, in the second direction, the substrate 100 is subjected to ion implantation to form the first well region 110 in the substrate 100.

In some embodiments, a lowest point of the first well region 110 is higher than a lowest point of the substrate 100, and a highest point of the first well region 110 is lower than a highest point of the substrate 100, i.e., the first well region 110 is disposed within the substrate 100.

In some embodiments, the STI structure 102 is partially disposed within the substrate 100 and partially protrudes from the substrate 100 to define multiple active areas (AA) in the substrate. The STI structures 102 extend along the second direction and are spaced apart in the first direction.
after the STI structure 102 is formed, removing the second dielectric layer 300 to expose a portion of the STI structure 102.
performing ion implantation in the substrate 100 to form a second well region 120 on a side of the substrate 100 adjacent to the first dielectric layer 200; where the first dielectric layer 200 serves as a barrier layer; a doping type of the second well region 120 is different from a doping type of the first well region 110.

Referring to FIGS. 5a and 5b, FIG. 5a is a schematic structural view of forming a second well region viewed in the first direction according to some embodiments of the present disclosure; FIG. 5b is a schematic structural view of forming the second well region viewed in the second direction according to some embodiments of the present disclosure.

As shown in FIG. 5a, in the first direction, the second dielectric layer 300 is removed to expose a portion of the STI structure 102, and the first dielectric layer 200 is used as a barrier layer to perform ion implantation in the substrate 100 to form the second well region 120 on a side of the substrate 100 adjacent to the first dielectric layer 200. As shown in FIG. 5b, in the second direction, the second dielectric layer 300 is removed to expose the first dielectric layer 200, and the first dielectric layer 200 is used as a barrier layer to perform ion implantation in the substrate 100, thereby forming the second well region 120 on a side of the substrate 100 adjacent to the first dielectric layer 200; where the second well region 120 is above the first well region 110.

In some embodiments, the first well region 110 and the second well region 120 have different doping types, i.e., the doping types of the first well region 110 and the second well region 120 are opposite. For example, when the first well region 110 is an N-type doped well region, the second well region 120 is a P-type doped well region; conversely, when the first well region 110 is a P-type doped well region, the second well region is an N-type doped well region.
forming a filling cover layer on the first dielectric layer, with the first dielectric layer and the filling cover layer serving as the hard mask layer 400; where the filling cover layer fills a space between each adjacent two STI structures 102 and covers the STI structures 102; the filling cover layer may be a multi-layer structure or a single-layer structure.

When the filling cover layer is multi-layered, the filling cover layer may include a filling layer 410 and a first protective layer 420. The filling layer 410 is formed on the first dielectric layer 200, where the filling layer 410 fills the space between adjacent STI structures 102; and the first protective layer 420 is formed on the filling layer 410 and the STI structures 102. Alternatively, the filling cover layer is single-layered, such as a silicon nitride layer, which is filled between each adjacent STI structures 102 and formed on the STI structures 102, in which case the first dielectric layer 200 also serves as part of the hard mask layer 400.

Referring to FIGS. 6a and 6b, FIG. 6a is a schematic structural view of forming a filling cover layer viewed in the first direction according to some embodiments of the present disclosure; FIG. 6b is a schematic structural view of forming the filling cover layer viewed in the second direction according to some embodiments of the present disclosure.

As shown in FIG. 6a, in the first direction, the filling layer 410 is formed on the first dielectric layer 200, the filling layer 410 fills the space between the adjacent two STI structures 102, and then the first protective layer 420 is formed on the filling layer 410 and the STI structures 102. The filling layer 410 and the first protective layer 420 constitute the filling cover layer, and the first dielectric layer 200, the filling layer 410, and the first protective layer 420 form the hard mask layer 400. As shown in FIG. 6b, in the second direction, the filling layer 410 is formed on the first dielectric layer 200, and then the first protective layer 420 is formed on the filling layer 410.

In some embodiments, the filling layer 410 may be a polycrystalline material filling layer, and the first protective layer may be an ON structure including a nitride layer and an oxide layer, such as an ON structure protective layer including a silicon nitride layer and a silicon oxide layer.

At block S 12: defining multiple first trenches in active areas of the substrate from the hard mask layer; where some of the first trenches are located in a memory region, and others of the first trenches are located in a lead-out region; a portion of each first trench in the substrate is defined as a base trench.

The first trenches are spaced apart in the second direction.

Referring to FIGS. 7a and 7b, FIG. 7a is a schematic structural view of defining multiple first trenches viewed in the first direction according to some embodiments of the present disclosure; FIG. 7b is a schematic structural view of defining the first trenches viewed in the second direction according to some embodiments of the present disclosure.

The multiple first trenches 103 are defined in the active areas of the substrate 100 from the hard mask layer 400. Some of the first trenches 103 are located in the memory region, and others of the first trenches 103 are located in the lead-out region. In the first direction, the first trenches 103 are separated by the STI structures 102, and in the second direction, the first trenches 103 are spaced apart.

As shown in FIG. 7a, in the first direction, a portion of the hard mask layer 400 on the STI structure 102 between adjacent first trenches 103 is removed to expose a portion of the STI structure 102, and then first trenches 103 are defined in the active areas between the STI structures 102. As shown in FIG. 7b, in the second direction, multiple first trenches 103 are defined in the active areas of the substrate 100 from the hard mask layer 400.

In some embodiments, the first trench 103 sequentially penetrates the first protective layer 420, the filling layer 410, the first dielectric layer 200, and the second well region 120, i.e., penetrating the hard mask layer 400 and the second well region 120, such that a bottom of the first trench 103 contacts the first well region 110, thereby exposing the first well region 110 through the first trench 103.

At block S13: forming a gate insulating layer and a semi-floating gate on a bottom of each base trench; where a portion of the semi-floating gate is in contact with the substrate, and another portion of the semi-floating gate is isolated from the substrate by the gate insulating layer.

The bottom of the base trench refers to a first trench segment 1031, i.e., the first trench segment 1031 is the bottom portion of the base trench where the semi-floating gate is formed.

The operation S13 may include: forming a gate insulating layer, a second gate, and a third gate on the bottom of the base trench, where the second gate is isolated from the substrate by the gate insulating layer, the third gate is in direct contact with the substrate, and the second gate and the third gate cooperate to form the semi-floating gate of a memory cell in the memory device. The specific operational process is as follows.
forming a first insulating layer on an inner wall of the base trench, filling the first trench with a second gate material, removing a portion of the second gate material and a portion of the first insulating layer to form a contact window, and forming a third gate material above the contact window.

Referring to FIGS. 8a and 8b, FIG. 8a is a schematic structural view of filling a second gate material viewed in the first direction according to some embodiments of the present disclosure; FIG. 8b is a schematic structural view of filling the second gate material viewed in the second direction according to some embodiments of the present disclosure.

As shown in FIG. 8a, in the first direction, the first insulating layer 104 is formed on the inner wall of the base trench. The first insulating layer 104 may be formed on the exposed substrate using a thermal oxidation process, and the second gate material 105 is filled into the first trench 103, such that the second gate material 105 covers the first trenches 103. As shown in FIG. 8b, in the second direction, the first insulating layer 104 is formed on the inner wall of the base trench, and the second gate material 105 is filled into the first trench 103, such that the second gate material 105 is flush with the hard mask layer 400, i.e., flush with the first protective layer 420.

In some embodiments, the second gate material 105 may be a polycrystalline material, such as polysilicon. After the second gate material 105 is filled, the second gate material 105 is chemically mechanically polished such that the second gate material 105 is flush with the first protective layer 420.

In some embodiments, when forming the first insulating layer 104 on the inner wall of the first trench 103 and filling the second gate material 105 into the first trench 103, the second gate material 105 further covers the STI structure 102, as shown in FIG. 8a.
removing a portion of the second gate material 105 within the first trench 103 and a corresponding portion of the first insulating layer 104 to form a contact window; where at least a portion of the first insulating layer within the first trench segment is removed.

Referring to FIGS. 9a and 9b, FIG. 9a is a schematic structural view of forming a contact window viewed in the first direction according to some embodiments of the present disclosure; FIG. 9b is a schematic structural view of forming the contact window viewed in the second direction according to some embodiments of the present disclosure.

As shown in FIG. 9b, in the second direction, a portion of the second gate material 105 and a corresponding portion of the first insulating layer 104 within the first trench 103 are removed, and a portion of the second gate material 105 and a portion of the first insulating layer 104 within the first trench segment 1031 of the base trench are removed, forming a contact window. As shown in FIG. 9a, in the first direction, the structure shown in FIG. 8a is maintained.

The base trench includes the first trench segment 1031 and a second trench segment 1032, with the second trench segment 1032 located above the first trench segment 1031. That is, the first trench segment 1031 forms the bottom portion of the first trench 103, and the first trench segment 1031 is configured to accommodate a second gate and a third gate, while the second trench segment 1032 is configured to accommodate a first gate layer.

In some embodiments, the removal method may involve photolithography or etching.
filling the third gate material into an unoccupied region of the first trench 103, i.e., forming the third gate material above the contact window; where the third gate material in the first trench segment 1031 contacts the substrate through the contact window.

Referring to FIGS. 10a and 10b, FIG. 10a is a schematic structural view of filling a third gate material viewed in the first direction according to some embodiments of the present disclosure; FIG. 10b is a schematic structural view of filling the third gate material viewed in the second direction according to some embodiments of the present disclosure.

As shown in FIG. 10a, in the first direction, the structure shown in FIG. 9a is maintained. As shown in FIG. 10b, in the second direction, after removing a portion of the second gate material 105 and a corresponding portion of the first insulating layer 104 within the first trench 103, an unoccupied region of the first trench 103 is formed, and the third gate material 106 is filled into the unoccupied region of the first trench 103, that is, form the third gate material 106 above the contact window. Then, chemical mechanical polishing is performed to make the filled surface smooth. Since at least part of the first insulating layer 104 in the first trench segment 1031 is removed to form the contact window, the third gate material 106 in the first trench segment 1031 can contact the substrate 100 through the contact window, such as contacting the second well region 120.

The third gate material may be formed using epitaxial growth or deposition processes. In some embodiments, the third gate material is formed using an epitaxial growth process, ensuring that the region where the third gate material contacts the substrate is single-crystal material.
after the third gate material 106 is filled, removing a portion of the second gate material 105, a portion of the third gate material 106, and a portion of the first insulating layer 104 within the first trench 103, and retaining a portion of the second gate material 105, a portion of the third gate material 106, and a portion of the first insulating layer 104 on the bottom of the base trench (i.e., in the first trench segment 1031); where the second gate material 105, the third gate material 106, and the first insulating layer 104 remaining in the first trench segment 1031 serve as a second gate 1051, a third gate 1061, and a gate insulating layer, respectively. Referring to FIGS. 11a and 11b, FIG. 11a is a schematic structural view of removing portions of the second gate material, the third gate material, and a first insulating layer in the first trench viewed in the first direction according to some embodiments of the present disclosure; FIG. 11b is a schematic structural view of removing portions of the second gate material, the third gate material, and the first insulating layer in the first trench viewed in the second direction according to some embodiments of the present disclosure.

As shown in FIG. 11b, in the second direction, a portion of the second gate material 105, a portion of the third gate material 106, and a portion of the first insulating layer 104 in the first trench 103 are removed, while the second gate material 105, the third gate material 106, and the first insulating layer 104 in the first trench segment 1031 are retained. The second gate material 105 retained in the retained first trench segment 1031 serves as the second gate 1051, the third gate material 106 retained in the retained first trench segment 1031 serves as the third gate 1061, and the first insulating layer 104 retained in the retained first trench segment 1031 serves as the gate insulating layer 1041. The bottom of the base trench retaining the second gate 1051, third gate 1061, and gate insulating layer 1041 constitutes the first trench segment 1031.

In some embodiments, when removing a portion of the second gate material 105, a portion of the third gate material 106, and a portion of the first insulating layer 104 within the first trench 103, a portion of the second gate material 105 covering the STI structure 102 is simultaneously removed, thereby continuing to expose the portion of the STI structure 102.

As shown in FIG. 11a, in the first direction, the second gate material 105 covering the STI structure 102 is simultaneously removed, exposing the STI structure 102.
reducing a height of the STI structure to form a first isolation portion.

In other embodiments, the first insulating layer 104 is formed on the inner wall of the base trench, and sacrificial material is formed on the first insulating layer 104, with the sacrificial material filling the first trench 103; a portion of the sacrificial material and a portion of the first insulating layer 104 are removed to form a contact window on the side wall of the first trench segment 1031 of the base trench. The remaining sacrificial material is removed and then a gate material is filled; a portion of the gate material and a portion of the first insulating layer 104 within the first trench 103 are removed to form a semi-floating gate and a gate insulating layer in the first trench segment 1031.

In this process, the remaining gate material forms the semi-floating gate, and the remaining first insulating layer forms the gate insulating layer. A portion of the semi-floating gate contacts the substrate through the contact window, while another portion of the semi-floating gate is isolated from the substrate by the gate insulating layer.

The sacrificial material may be a silicon-rich composite material or other suitable dielectric material. In this case, the remaining gate material in the first trench segment 1031 serves as the semi-floating gate, and the remaining first insulating layer 104 in the first trench segment 1031 serves as the gate insulating layer.

The following process is described using the semi-floating gate including the second gate and third gate as an example.

Referring to FIGS. 12a and 12b, FIG. 12a is a schematic structural view of forming a first isolation portion viewed in the first direction according to some embodiments of the present disclosure; FIG. 12b is a schematic structural view of forming the first isolation portion viewed in the second direction according to some embodiments of the present disclosure.

As shown in FIG. 12a, in the first direction, based on FIG. 11a, an exposed portion of the STI structure 102 is removed, i.e., the height of the STI structure 102 is reduced, such that the height of the STI structure 102 is no higher than the height of the semi-floating gate, thereby forming the first isolation portion. As shown in FIG. 12b, in the second direction, the structure shown in FIG. 11b may be maintained.

In some embodiments, when lowering the height of the STI structure 102 to form the first isolation portion, the remaining STI structure 102 may be flush with the semi-floating gate to serve as the first isolation portion.

Referring to FIGS. 13a and 13b, FIG. 13a is a schematic structural view of further lowering the STI structure to form another first isolation portion viewed in the first direction according to some embodiments of the present disclosure; FIG. 13b is a schematic structural of further lowering the STI structure to form another first isolation portion view viewed in the second direction according to some embodiments of the present disclosure.

As shown in FIG. 13a, in the first direction, based on FIG. 12a, a portion of the STI structure 102 is removed such that the height of the STI structure 102 is lower than the height of the semi-floating gate, and the remaining portion of the STI structure 102 serves as the first isolation portion. As shown in FIG. 13b, in the second direction, the first protective layer 420 may be removed.

In some embodiments, the removal process may involve wet etching followed by dry etching.

At block S14: forming an inter-gate dielectric layer and a first gate layer in each first trench, removing a portion of the first gate layer in each first trench in the memory region to form a control gate of a corresponding memory cell, and retaining the first gate layer in each first trenches in the lead-out region as a lead-out line of a corresponding memory cell; where the lead-out line is connected to the control gates of memory cells in a same row as the lead-out line, as shown in FIGS. 16a and 16b.

The operational flow of the operation S14 may include the following.
forming the inter-gate dielectric layer, where the inter-gate dielectric layer at least covers the semi-floating gate.

Referring to FIGS. 14a and 14b, FIG. 14a is a schematic structural view of forming an inter-gate dielectric layer viewed in the first direction according to some embodiments of the present disclosure; FIG. 14b is a schematic structural view of forming the inter-gate dielectric layer viewed in the second direction according to some embodiments of the present disclosure.

As shown in FIG. 14a, in the first direction, based on FIG. 13a, the inter-gate dielectric layer 500 is formed such that the inter-gate dielectric layer 500 covers the first isolation portion and the semi-floating gate in the first trench segment 1031, forming a tooth-like structure, thereby increasing the coupling area between the semi-floating gate and the control gate. As shown in FIG. 14b, in the second direction, the inter-gate dielectric layer 500 is formed such that the inter-gate dielectric layer 500 covers a portion of the first trench 103 above the semi-floating gate formed by the second gate 1051 and the third gate 1061, as well as the remaining hard mask layer 400 in a region between two adjacent first trenches.
covering a first gate material on the inter-gate dielectric layer, and removing an excess portion of the first gate material until a remaining portion of the first gate material is flush with a highest point of the first trench, i.e., the first gate material is flush with the highest point of the first trench.

Referring to FIGS. 15a and 15b, FIG. 15a is a schematic structural view of covering a first gate material viewed in the first direction according to some embodiments of the present disclosure; FIG. 15b is a schematic structural view of covering the first gate material viewed in the second direction according to some embodiments of the present disclosure.

As shown in FIG. 15a, in the first direction, based on FIG. 14a, the first gate material 600 is deposited on the inter-gate dielectric layer 500, and excess first gate material 600 is removed such that the first gate material 600 is flush with the highest point of the first trench 103. As shown in FIG. 15b, in the second direction, based on FIG. 14b, the first gate material 600 is deposited on the inter-gate dielectric layer 500, and excess first gate material 600 is removed such that the first gate material 600 is flush with the highest point of the first trench 103.
removing a portion of the first gate material in each first trench 103 in the memory region and the first gate material on the first isolation portion, until a remaining portion of the first gate material in each first trench 103 in the memory region is no higher than the highest point of the base trench, and retaining the first gate material in each first trench 103 in the lead-out region as a first gate layer in the lead-out region, which serves as the lead-out line of a corresponding memory cell; where the remaining portion of the first gate material in each first trench 103 in the memory region serves as the first gate layer in the memory region to form a control gate of a corresponding memory cell.

Referring to FIGS. 16a and 16b, FIG. 16a is a schematic structural view of removing portions of the first gate material viewed in the first direction according to some embodiments of the present disclosure; FIG. 16b is a schematic structural view of removing portions of the first gate material viewed in the second direction according to some embodiments of the present disclosure.

As shown in FIG. 16b, in the second direction, based on FIG. 15b, a portion of the first gate material 600 in the first trench 103 in the memory region is removed to form a spare region 1033. In some embodiments, the remaining first gate material 600 is not higher than the highest point of the base trench, and the remaining first gate material 600 serves as the first gate layer 610, i.e., the height of the control gate in the memory region is not higher than the height of the base trench.

To more fully illustrate the structure of the device, the left side of the dashed line in FIG. 16b is a cross-sectional view showing the spare region 1033 formed in the second direction, corresponding to the cross-sectional view in the memory region in the Y1 direction in FIG. 19; the right side of the dashed line in FIG. 16b is a cross-sectional view of the first gate material 600 retained in the first trench 103 in the second direction, with the retained first gate material 600 serving as a control gate contact region, i.e., the lead-out region, corresponding to the cross-sectional view in the lead-out region in the Y2 direction in FIG. 19. As shown in FIG. 16b, the first gate material 600 above the base trench in the memory region is removed to form the first gate layer 610. As shown in FIG. 16a, from the first direction, an unoccupied region 620 is formed.
forming a second insulating layer 700 on the spare region 1033 of the first trench 103 and the remaining first gate material on the first isolation portion.

Referring to FIGS. 17a and 17b, FIG. 17a is a schematic structural view of forming a second insulating layer viewed in the first direction according to some embodiments of the present disclosure; FIG. 17b is a schematic structural view of forming a first trench in the second insulating layer viewed in the second direction according to some embodiments of the present disclosure.

As shown in FIG. 17a, in the first direction, based on FIG. 16a, the second insulating layer 700 is formed in the unoccupied region 620 of the first gate material 600. As shown in FIG. 17b, in the second direction, based on FIG. 16b, the second insulating layer 700 is formed in the spare region 1033 of the first trench 103, and chemical mechanical polishing is performed to make the surface flat. The material of the second insulating layer 700 may be, for example, silicon oxide.

In some embodiments, in the second direction (as shown in the Y2 direction in FIG. 19), the first gate material in the first trench 103 of the column in the lead-out region is completely retained; where the first gate material 600 retained in the first trench 103 of the column in the lead-out region serves as the connection point for the control gate in the memory cell, enabling the connection between the first gate layer 610 in the memory region and the external environment.

In some embodiments, in the first direction, at least one first trench in the lead-out region is shielded after every predetermined number of first trenches, retaining part of the first gate material 600 in the first trench 103 in the lead-out region; in the first direction, the first gate material 600 retained in the first trenches of the same row serves as the connection point for all control gates in the memory cells of that row, enabling the connection between the first gate layer 610 in the memory region of the same row and the external environment. A gate contact region, i.e., a lead-out region, may be formed at a fixed distance BL, such as every 32 columns BL, such that the first gate layer 610 is connected to the outside through the gate contact region.

In some embodiments, the hard mask layer may be removed from the memory device, where a second isolation portion is a portion of the STI structure 102 exposed from the first isolation portion.

Referring to FIGS. 18a, 18b, and 19, FIG. 18a is a schematic structural view of removing portions of the first insulating layer and the filling cover layer viewed in the first direction according to some embodiments of the present disclosure; FIG. 18b is a schematic structural view of removing portions of the first insulating layer and the filling cover layer viewed in the second direction according to some embodiments of the present disclosure; FIG. 19 is a top view of a memory device according to some embodiments of the present disclosure.

As shown in FIG. 19, in the first direction, the structure may be divided into two types of regions. X1 is a first type of region in the first direction, and the aforementioned FIG. [x]a (x refers to 1-18) are cross-sectional views of the first type of region in the first direction. The first isolation portion is located in the first type of region X1 in the first direction. X2 is a second type of region in the first direction, and the second isolation portion is located in the second type of region X2 in the first direction. In the second direction, the structure may be divided into three types of regions. Y1 is a first type of region in the second direction, i.e., the memory region. The dashed lines on the left side of the aforementioned FIG. [x]b are cross-sectional views of the first type of region Y1 in the second direction. Y2 is a second type of region in the second direction, and the dashed lines on the right side of the aforementioned FIG. [x]b are cross-sectional views of the second type of region Y2 in the second direction, i.e., the lead-out region. The third gate material in the second type of region Y2 in the second direction can serve as a contact region connected to the external environment. Y3 is the cross-sectional view of a third type of region in the second direction, i.e., the cross-sectional view of the STI structure, which also belongs to the memory region.

In the first direction, the first insulating layer 104 and the hard mask layer 400 on the second isolation portion of the STI structure in the second type of region in the first direction are removed. FIG. 18a shows the cross-sectional view of the first type of region in the first direction, i.e., the first isolation portion without the first insulating layer 104 and the hard mask layer 400. As shown in FIG. 18b, in the second direction, the first insulating layer 104 and the hard mask layer 400 on the region between adjacent base trenches and on the second isolation portion of the STI structure 102 in the second direction are removed.

In some embodiments, in the Y3 direction, the first isolation portion and the second isolation portion are alternately spaced apart; the second insulating layer remaining on the base trench and the third gate material remaining on the base trench are located in the second direction at different X-axis coordinates.

A spacer may be formed.

Referring to FIGS. 20a and 20b, FIG. 20a is a schematic structural view of forming an isolation barrier wall viewed in the first direction according to some embodiments of the present disclosure; FIG. 20b is a schematic structural view of forming the isolation barrier wall viewed in the second direction according to some embodiments of the present disclosure.

As shown in FIG. 20a, in the first direction, the structure is as shown in FIG. 18a. As shown in FIG. 20b, in the second direction, the spacer 800 is formed on both sides of the second insulating layer 700 and/or both sides of the first gate material 600 remaining on each base trench, i.e., a spacer 800 is formed on both sides of the second insulating layer 700 remaining on the base trench in the memory region, as shown on the left side of the dashed line in FIG. 20b. On the base trench in the lead-out region, a spacer 800 is formed on both sides of the first gate 610, as shown on the right side of the dashed lines in FIG. 20b.

Referring to FIGS. 21a and 21b, FIG. 21a is a schematic structural view of forming a contact plug in an interlayer dielectric (ILD) layer viewed in the first direction according to some embodiments of the present disclosure; FIG. 21b is a schematic structural view of forming the contact plug in the ILD layer viewed in the second direction according to some embodiments of the present disclosure.

As shown in FIGS. 21a and 21b, an interlayer dielectric (ILD) layer 900 is formed over the entire top view plane of the memory device, covering the aforementioned structure. Contact plugs 910 are formed in the interlayer dielectric layer 900, enabling the contact plugs 910 to connect all control gates of the same row of memory cells.

In some embodiments, ion implantation is performed in the substrate on both sides of the first trench 103 to form source and drain regions; the first dielectric layer 200 is removed, and a metal silicide layer 210 is formed on the source region, drain region, and control gates; the source region and drain region may be provided with corresponding contact plugs to connect to the outside.

The present disclosure further provides a memory device, as shown in FIGS. 21a, 21b, and 19. The cross-sectional view of the first type of region X1 in the first direction serves as the cross-sectional view of the memory device in the first direction, and the cross-sectional views of the first type of region Y1 in the second direction and the second type of region Y2 in the second direction serve as the cross-sectional view of the memory device in the second direction. The region to the left of the dashed line is the cross-sectional view of the first type of region Y1 in the second direction, and the region to the right of the dashed line is the cross-sectional view of the second type of region Y2 in the second direction.

The memory device includes a substrate, a base trench, a semi-floating gate, an inter-gate dielectric layer, and a first gate layer.

The base trench extends from one side surface of the substrate 100 toward the substrate 100, and there are multiple base trenches, with some located in the memory arranged and others located in the lead-out region. The inner wall at the bottom of each base trench is provided with a gate insulating layer 1041, as shown in FIG. 21b.

The semi-floating gate fills the bottom of the base trench. A portion of the semi-floating gate is isolated from the substrate 100 by the gate insulating layer 1041, while another portion of the semi-floating gate contacts the substrate 100.

The base trench includes a first trench segment and a second trench segment. The bottom of the base trench, which retains a second gate 1051, a third gate 1061, and the gate insulating layer 1041, is the first trench segment, and the second trench segment is located above the first trench segment.

The inter-gate dielectric layer 500 covers the semi-floating gate.

A first gate layer 610 is formed on the inter-gate dielectric layer 500, where the first gate layer in the memory region constitutes the control gate of the memory cell in the memory device, and the first gate layer in the lead-out region serves as the lead-out line, which connects the control gates of multiple memory cells in the same row.

In some embodiments, shallow trench isolation (STI) structures 102 are formed in the substrate 100, and the STI structures are spaced apart along the first direction and extend along the second direction; where the STI structure includes a first isolation portion and a second isolation portion that are spaced apart; the first isolation portion is disposed within the substrate, and the second isolation portion protrudes from the substrate. As shown in FIG. 21a, in the first type of region X1 in the first direction, the STI structure 102 is formed within the substrate, i.e., the height of the STI structure is lower than the height of the substrate. In the second type of region X2 in the first direction, the height of the STI structure is higher than the height of the substrate, thereby isolating the memory cells within the memory devices. The STI structures 102 are spaced apart along the first direction and extend along the second direction, as shown in FIG. 19. In the first type of region X1 in the first direction, the STI structure 102 includes a first isolation portion formed between two adjacent base trenches in the first direction, with the highest point of the first isolation portion in the third direction being lower than the highest point of the base trench in the third direction. In the second type of region X2 in the first direction, the STI structure 102 includes a second isolation portion, with the highest point of the second isolation portion in the third direction being higher than the highest point of the base trench in the third direction. That is, the first isolation portion and the second isolation portion are spaced apart, with the first isolation portion being disposed within the substrate and the second isolation portion protruding from the substrate; the third direction is the vertical direction.

In some embodiments, the semi-floating gate includes a second gate 1051 and a third gate 1061; the second gate 1051 is isolated from the substrate 100 by the gate insulating layer 1041, and the third gate 1061 is in direct contact with the substrate 100; the inter-gate dielectric layer 500 covers the second gate 1051 and the third gate 1061.

In some embodiments, the inter-gate dielectric layer 500 further covers the first isolation portion.

In some embodiments, at least the third gate at the contact point with the substrate is made of single-crystal material.

In some embodiments, the first gate layer 610 includes a first-gate first portion filled in the base trench and a first-gate second portion located on the first isolation portion. In the second direction, the first-gate first portions in adjacent base trenches are isolated from each other, i.e., the control gates in adjacent base trenches are isolated from each other. In the first direction, the control gates in adjacent base trenches are connected to each other via the first gate layer on the first isolation portion between them.

In some embodiments, the height of the control gate is not higher than the height of the base trench. The first gate layer further includes at least one first-gate third portion, i.e., the lead-out line, as a connection point. That is, the height of the first gate layer in the base trench in the lead-out region is higher than the height of the base trench and serves as a connection point for connecting the control gate to the outside. The control gate is connected to the lead-out line via the first gate layer on the first isolation layer.

In the first direction, at least one corresponding lead-out line is provided for every predetermined number of control gates, with the lead-out line serving as a connection point to connect the control gates in the same row to the external environment.

In some embodiments, the memory device further includes: a second insulating layer, a spacer 800, an interlayer dielectric layer 900, and contact plugs 910. The second insulating layer covers the first gate layer in base trench in the memory region. The spacer 800 is located on both sides of the second insulating layer 700 and/or both sides of the first gate layer remaining on the base trench, i.e., spacers are formed on both sides of the second insulating layer in the memory region, and spacers are formed on both sides of the first gate layer in the lead-out region. The interlayer dielectric layer 900 covers the substrate 100, the second insulating layer 700, and/or the first gate layer remaining on the base trench. The contact plugs 910 are located within the interlayer dielectric layer 900, where the contact plugs 910 are connected to the first gate layer on the base trench in the lead-out region.

In some embodiments, the contact plugs 910 may further be connected to a source-drain region divided by the base trenches.

In the present disclosure, the manufacturing method for a memory device includes: providing a semiconductor substrate, where the semiconductor substrate includes a substrate and a hard mask layer on the substrate; defining multiple first trenches in active areas of the substrate from the hard mask layer; where some of the first trenches are located in a memory region, and others of the first trenches are located in a lead-out region; a portion of each first trench in the substrate is defined as a base trench; forming a gate insulating layer and a semi-floating gate on a bottom of each base trench; where a portion of the semi-floating gate is in contact with the substrate, and another portion of the semi-floating gate is isolated from the substrate by the gate insulating layer; and forming an inter-gate dielectric layer and a first gate layer in each first trench, removing a portion of the first gate layer in each first trench in the memory region to form a control gate of a corresponding memory cell, and retaining the first gate layer in each first trenches in the lead-out region as a lead-out line of a corresponding memory cell; where the lead-out line is connected to the control gates of memory cells in a same row as the lead-out line. Through the above method, the lead-out lines in the lead-out region can be in contact with the external environment, solving the voltage drop issue caused by the high buried gate resistance of the control gates, while reducing the operating voltage of the memory device to lower power consumption.

The above description is merely some embodiments of the present disclosure and does not limit the scope of the present disclosure. Any equivalent structures or equivalent process variations made based on the content of the present disclosure and its drawings, or any direct or indirect application in other related technical fields, are all included within the scope of the present disclosure.

## Claims

1. A manufacturing method for a memory device, **characterized by** comprising:
providing a semiconductor substrate, wherein the semiconductor substrate comprises a substrate and a hard mask layer on the substrate;
defining a plurality of first trenches in active areas of the substrate from the hard mask layer; wherein some of the plurality of first trenches are located in a memory region, and others of the plurality of first trenches are located in a lead-out region; a portion of each first trench in the substrate is defined as a base trench;
forming a gate insulating layer and a semi-floating gate on a bottom of each base trench; wherein a portion of the semi-floating gate is in contact with the substrate, and another portion of the semi-floating gate is isolated from the substrate by the gate insulating layer; and
forming an inter-gate dielectric layer and a first gate layer in each first trench, removing a portion of the first gate layer in each first trench in the memory region to form a control gate of a corresponding memory cell, and retaining the first gate layer in each first trenches in the lead-out region as a lead-out line of a corresponding memory cell; wherein the lead-out line is connected to the control gates of memory cells in a same row as the lead-out line.

2. The manufacturing method according to claim 1, wherein a height of the control gate is not higher than a height of the base trench.

3. The manufacturing method according to claim 1, wherein the providing a semiconductor substrate comprises:
providing a substrate, and sequentially forming a first dielectric layer and a second dielectric layer on the substrate;
defining a plurality of second trenches from the second dielectric layer toward the substrate; wherein the second trenches are spaced apart along a first direction and each second trench extends along a second direction;
filling each second trench with an insulating material to form a shallow trench isolation, STI, structure, and performing ion implantation in the substrate to form a first well region in the substrate;
removing the second dielectric layer to expose a portion of the STI structure;
performing ion implantation on the substrate to form a second well region on a side of the substrate adjacent to the first dielectric layer; wherein the first dielectric layer serves as a barrier layer; a doping type of the second well region is different from a doping type of the first well region; and
forming a filling cover layer on the first dielectric layer, with the first dielectric layer and the filling cover layer serving as the hard mask layer; wherein the filling cover layer fills a space between each adjacent two STI structures and covers the STI structures.

4. The manufacturing method according to claim 1, wherein the forming a gate insulating layer and a semi-floating gate on a bottom of each base trench comprises:
forming a first insulating layer on an inner wall of the base trench, and forming a sacrificial material on the first insulating layer, with the sacrificial material filling the first trench corresponding to the base trench;
removing a portion of the sacrificial material and a portion of the first insulating layer to form a contact window;
removing a remaining portion of the sacrificial material, and filling a gate material in the first trench;
removing a portion of the gate material and a portion of the first insulating layer to form the semi-floating gate and the gate insulating layer on the bottom of the base trench; wherein a remaining portion of the gate material serves as the semi-floating gate, and a remaining portion of the first insulating layer serves as the gate insulating layer; wherein a portion of the semi-floating gate is in contact with the substrate by the contact window, and another portion of the semi-floating gate is isolated from the substrate by the gate insulating layer.

5. The manufacturing method according to claim 1, wherein the forming a gate insulating layer and a semi-floating gate on a bottom of each base trench comprises:
forming a gate insulating layer, a second gate, and a third gate on the bottom of the base trench, wherein the second gate is isolated from the substrate by the gate insulating layer, the third gate is in direct contact with the substrate, and the second gate and the third gate cooperate to form the semi-floating gate of a memory cell in the memory device.

6. The manufacturing method according to claim 5, wherein the forming a gate insulating layer, a second gate, and a third gate on the bottom of the base trench comprises:
forming a first insulating layer on an inner wall of the base trench, filling the first trench with a second gate material;
removing a portion of the second gate material and a portion of the first insulating layer to form a contact window, and forming a third gate material above the contact window;
removing a portion of the second gate material, a portion of the third gate material, and a portion of the first insulating layer, and retaining another portion of the second gate material, another portion of the third gate material, and another portion of the first insulating layer in a first trench segment of the base trench; wherein a remaining portion of the second gate material serves as the second gate, a remaining portion of the third gate material serves as the third gate, and a remaining portion of the first insulating layer serves as the gate insulating layer.

7. The manufacturing method according to claim 5, wherein at least a portion of the third gate that is in contact with the substrate is made of a single crystalline material.

8. The manufacturing method according to claim 1, wherein the substrate is arranged with shallow trench isolation (STI) structures; a portion of each STI structure is disposed within the substrate, and another portion of the STI structure is exposed from the substrate; the STI structures are spaced apart along a first direction and each STI structure extends along a second direction;
after the gate insulating layer and the semi-floating gate are formed on the bottom of the base trench, a portion of each STI structure is removed to form a first isolation portion; wherein a height of a remaining portion of the STI structure in the first isolation portion is not higher than a height of the semi-floating gate.

9. The manufacturing method according to claim 1, wherein the forming an inter-gate dielectric layer and a first gate layer in each first trench, removing a portion of the first gate layer in each first trench in the memory region to form a control gate of a corresponding memory cell, and retaining the first gate layer in each first trenches in the lead-out region as a lead-out line of a corresponding memory cell comprise:
forming the inter-gate dielectric layer, wherein the inter-gate dielectric layer at least covers the semi-floating gate;
covering a first gate material on the inter-gate dielectric layer, wherein the first gate material is flush with a highest point of the first trench; and
removing a portion of the first gate material in each first trench in the memory region, until a remaining portion of the first gate material in each first trench in the memory region is not higher than the highest point of the base trench corresponding to the first trench; and retaining the first gate material in each first trench in the lead-out region as the lead-out line of a corresponding memory cell; wherein the remaining portion of the first gate material in each first trench in the memory region serves as the first gate layer in the memory region to form the control gate of a corresponding memory cell.

10. The manufacturing method according to claim 9, wherein in the first direction, among the first trenches in the lead-out region, at least one first trench is shielded after every predetermined number of first trenches, and a portion of the first gate material in each of the at least one first trench in the lead-out region is retained;
in the first direction, the first gate material retained in each of the first trenches of a same row serves as a connection point for all the control gates in the memory cells of the same row, enabling a connection between the first gate layers of the same row in the memory region and an external environment.

11. The manufacturing method according to claim 9, further comprising:
forming a second insulating layer on a spare region of the first trench;
removing the hard mask layer;
forming a spacer on both sides of the second insulating layer and/or both sides of the first gate material;
forming an interlayer dielectric (ILD) layer;
forming contact plugs in the interlayer dielectric layer; wherein the contact plugs are connected to the first gate material in the lead-out region.

12. A memory device, **characterized by** comprising:
a substrate;
a plurality of base trenches; wherein each base trench extends from a side surface of the substrate toward the substrate; some of the plurality of base trenches are located in a memory region, and others of the plurality of base trenches are located in a lead-out region; an inner wall on a bottom of each base trench is arranged with a gate insulating layer;
a semi-floating gate; wherein the semi-floating gate fills the bottom of the base trench; a portion of the semi-floating gate is isolated from the substrate by the gate insulating layer, and another portion of the semi-floating gate is in contact with the substrate;
an inter-gate dielectric layer, covering the semi-floating gate; and
a first gate layer, formed on the inter-gate dielectric layer; wherein the first gate layer in the memory region constitutes a control gate of a corresponding memory cell in the memory device, and the first gate layer in the lead-out region serves as a lead-out line, which connects the control gates of memory cells in a same row.

13. The memory device according to claim 12, wherein the semi-floating gate comprises a second gate and a third gate; the second gate is isolated from the substrate by the gate insulating layer, and the third gate is in contact with the substrate.

14. The memory device according to claim 13, wherein at least a portion of the third gate that is in contact with the substrate is made of a single crystalline material.

15. The memory device according to claim 12, wherein shallow trench isolation, STI, structures are formed in the substrate, and the STI structures are spaced apart along a first direction and extend along a second direction; each STI structure comprises a first isolation portion and a second isolation portion that are spaced apart; the first isolation portion is disposed within the substrate, and the second isolation portion protrudes from the substrate.

16. The memory device according to claim 15, wherein the control gate and the lead-out line are connected via the first gate layer on the first isolation portion.

17. The memory device according to claim 12, wherein a height of the control gate is not higher than a height of the base trench; a height of the first gate layer in the base trench in the lead-out region is higher than the height of the base trench, with the first gate layer serving as a connection point for connecting the control gate to an external environment.

18. The memory device according to claim 12, wherein at least one corresponding lead-out line is provided for every predetermined number of the control gates, with each lead-out line serving as a connection point to connect the control gates in a same row to an external environment.

19. The memory device according to claim 12, further comprising:
a second insulating layer, covering the first gate layer in the base trench in the memory region;
a spacer, disposed on both sides of the second insulating layer and/or both sides of the first gate layer remaining on the base trench;
an interlayer dielectric layer, covering the substrate and the second insulating layer and/or the first gate layer remaining on the base trench; and
contact plugs, disposed within the interlayer dielectric layer; wherein the contact plugs are connected to the first gate layer in the lead-out region.
